# EUROPEAN PATENT APPLICATION

(11) **EP 3 647 920 A1**
(43) Date of publication of application: **06.05.2020**
(21) Application number: 19205639.8
(22) Date of filing: 28.10.2019
(51) Int. Cl.: G06F 3/041, G06F 3/044

(54) **TOUCH DISPLAY APPARATUS**

(30) Priority: 31.10.2018 CN 201811283710
(71) Applicant: Coretronic Corporation, Hsin-Chu 300 (TW)
(72) Inventor: KUO, Pen-Ning, 300 Hsinchu (TW); CHEN, Jui-Chi, 300 Hsinchu (TW); YIN, Nan-Jiun, 300 Hsinchu (TW)
(74) Representative: Ter Meer Steinmeister & Partner

(57) **Abstract**

A touch display apparatus is provided. The touch display apparatus including at least one touch display unit, and the at least one touch display unit includes a first surface, a plurality of light-emitting elements, a first touch electrode layer and a second touch electrode layer. The plurality of light-emitting elements are located on the first surface. The first touch electrode layer is located on the first surface, and has a plurality of first axial electrodes extending along a first direction. The second touch electrode layer has a plurality of second axial electrodes extending along a second direction. Orthographic projections of the first axial electrodes on the first surface and orthographic projections of the second axial electrodes on the first surface commonly surround a plurality of closed regions, and the plurality of light-emitting elements are respectively located in the corresponding closed regions.

## Description

This application claims the priority of CN 201811283710.4, filed on October 31, 2018.

### BACKGROUND

### Technical Field

The invention relates to a touch display apparatus, and particularly relates to a touch control display apparatus having a Light-Emitting Diode (LED) display screen.

### Description of Related Art

Along with development of semiconductor techniques, the size of displays has also become larger. The commonly used displays include flat panel displays such as liquid crystal displays and plasma displays for home viewing and Light-Emitting Diode (LED) displays applied to large outdoor advertising billboards, etc. Moreover, along with rapid development and wide application of information technology, wireless communication and information appliances, users are also accustomed to operate the display devices by touch operations. Therefore, how to make the large-scale displays to also have the touch function is one of the future development trends.

Regarding an LED display applied to the large outdoor advertising billboards, a plurality of LED modules in the LED display is arranged in an array to present a required size. Moreover, current touch panels of the LED displays are mainly based on optical touch technology. The optical touch technology may be roughly divided into two types: an interruption type and a Frustrated Total Internal Reflection (FTIR) type. The interruption type is implemented by setting a detector and an emitter at an edge of the panel, or by setting an emitter and a corresponding detector at corners of a same side of a substrate, and setting a reflecting structure at other edge of the substrate, so as to detect light blocked by a finger to determine a touch point. However, the above detection is limited by that the detector or a light source, etc. has to be set at periphery of a panel operation surface, and the periphery of the panel operation surface is required to set a border to shield devices such as the detector to result in a height difference, so that a borderless design cannot be implemented. On the other hand, the FTIR optical touch technique is implemented by contacting a light guide plate (LGP) by a finger to spoil a transmission path of total internal reflection (TIR) light in the LGP, so that the original TIR light leaks downward (an inner side of a touch element), and a sensing surface of an infrared sensor is adhered to a lower surface of the LGP to sense a light intensity variation in the LGP, so as to implement image identification to observe a touch point thereof. However, such detection method has to set up the sensors based on a surface area, so that when it is applied to a large-scale display, a large amount of infrared sensors has to be added, which results in high cost and a complicated circuit design.

Moreover, the aforementioned two optical touch methods also have following shortages: first, the above two optical touch methods are easy to be interfered by external environmental light source, which is of no avail for real touch position detection; second, due to the optical limitation, when the finger only approaches to the surface of the touch panel without touching the same, the finger may be determined to perform a touch operation to cause misjudgement; third, it may also cause misjudgement or abnormal sensitivity due to light interference caused by dust.

The information disclosed in this Background section is only for enhancement of understanding of the background of the described technology and therefore it may contain information that does not form the prior art that is already known to a person of ordinary skill in the art. Further, the information disclosed in the Background section does not mean that one or more problems to be resolved by one or more embodiments of the invention was acknowledged by a person of ordinary skill in the art.

### SUMMARY

The invention is directed to a touch display apparatus, which has low cost and good reliability.

Other objects and advantages of the invention may be further illustrated by the technical features broadly embodied and described as follows.

The object is solved by the features of the independent claims. Preferred embodiments are given in the dependent claims.

In order to achieve one or a portion of or all of the objects or other objects, an embodiment of the invention provides a touch display apparatus. The touch display apparatus includes at least one touch display unit, and the at least one touch display unit includes a first surface, a plurality of light-emitting elements, a first touch electrode layer and a second touch electrode layer. The plurality of light-emitting elements are located on the first surface. The first touch electrode layer is located on the first surface, and has a plurality of first axial electrodes extending along a first direction. The second touch electrode layer has a plurality of second axial electrodes extending along a second direction. Orthographic projections of the first axial electrodes on the first surface and orthographic projections of the second axial electrodes on the first surface commonly surround a plurality of closed regions, and the plurality of light-emitting elements are respectively located in the corresponding closed regions.

Preferably, the at least one touch display unit may have a bottom surface.

Preferably, the first surface is opposite to the bottom surface.

Preferably, the at least one touch display unit further comprises a plurality of driving units, located on the bottom surface.

Preferably, the plurality of light-emitting elements are electrically connected to the plurality of driving units.

Preferably, the touch display apparatus may further comprise a grounding layer.

Preferably, the grounding layer may be located between the plurality of driving units and the second touch electrode layer.

Preferably, the at least one touch display unit may further comprise a printed circuit board located between the plurality of driving units and the second touch electrode layer.

Preferably, the printed circuit board may present a black color.

Preferably, the number of the at least one touch display unit may be plural.

Preferably, the touch display apparatus may further comprise a plurality of first leads, a first touch electrode layer connection terminal and a second touch electrode layer connection terminal.

Preferably, the first leads may respectively have first ends and second ends.

Preferably, the first ends of the first leads may be respectively electrically connected to the first touch electrode layer connection terminal and the second touch electrode layer connection terminal.

Preferably, the touch display apparatus may further comprise a control unit.

Preferably, the control unit may be connected to the second ends of the plurality of first leads.

Preferably, the control unit may be electrically connected to the first touch electrode layer connection terminal and the second touch electrode layer connection terminal of the plurality of touch display units through the plurality of first leads.

Preferably, the plurality of touch display units may be arranged in an array.

Preferably, the touch display apparatus may further comprise a hardened layer, covering the plurality of light-emitting elements.

Preferably, the plurality of light-emitting elements and the first touch electrode layer may be located on a same plane.

Preferably, the touch display apparatus may further comprise an optical film.

Preferably, the optical film may cover the plurality of light-emitting elements.

Preferably, the optical film may have a first side and a second side opposite to each other.

Preferably, the first touch electrode layer and the second touch electrode layer of the at least one touch display unit may be respectively located on the first side and the second side of the optical film.

Preferably a cover may be located on the optical film.

Preferably, the second touch electrode layer is located between the plurality of light-emitting elements and the first touch electrode layer.

Based on the above description, the embodiment of the invention has at least one of following advantages or effects. In the embodiment of the invention, based on configuration of the first touch electrode layer and the second touch electrode layer in the touch display unit, the touch display apparatus may sense and calculate a touch position according to a capacitance variation of the axial electrodes therein, so as to implement the touch function. Moreover, since the touch display apparatus integrates a display device and a capacitive touch technique and simultaneously implements the display function and the touch function based on the configuration that the light-emitting elements and the first touch electrode layer are all located on the first surface, it is not affected by environmental light and dust, and is not easy to cause misjudgement, and has good reliability. The touch display apparatus may also achieve a borderless effect based on the configuration of the leads on the bottom surface, and the touch display units may be designed and arranged according to an actual requirement, and may be arbitrarily expanded to form different contours of the touch display apparatus.

Other objectives, features and advantages of the present invention will be further understood from the further technological features disclosed by the embodiments of the present invention wherein there are shown and described preferred embodiments of this invention, simply by way of illustration of modes best suited to carry out the invention.

### BRIEF DESCRIPTION OF THE DRAWINGS

The accompanying drawings are included to provide a further understanding of the invention, and are incorporated in and constitute a part of this specification. The drawings illustrate embodiments of the invention and, together with the description, serve to explain the principles of the invention.
FIG. 1A is a top view of a touch display apparatus according to an embodiment of the invention.
FIG. 1B is an enlarged view of a touch display unit of FIG. 1A.
FIG. 1C is a cross-sectional view of the touch display unit of FIG. 1B.
FIG. ID is a schematic diagram of a bottom view of the touch display apparatus of FIG. 1A.
FIG. 2 is a cross-sectional view of another touch display unit according to an embodiment of the invention.

### DESCRIPTION OF The EMBODIMENTS

In the following detailed description of the preferred embodiments, reference is made to the accompanying drawings which form a part hereof, and in which are shown by way of illustration specific embodiments in which the invention may be practiced. In this regard, directional terminology, such as "top," "bottom," "front," "back," etc., is used with reference to the orientation of the Figure(s) being described. The components of the present invention can be positioned in a number of different orientations. As such, the directional terminology is used for purposes of illustration and is in no way limiting. On the other hand, the drawings are only schematic and the sizes of components may be exaggerated for clarity. It is to be understood that other embodiments may be utilized and structural changes may be made without departing from the scope of the present invention. Also, it is to be understood that the phraseology and terminology used herein are for the purpose of description and should not be regarded as limiting. The use of "including," "comprising," or "having" and variations thereof herein is meant to encompass the items listed thereafter and equivalents thereof as well as additional items. Unless limited otherwise, the terms "connected," "coupled," and "mounted" and variations thereof herein are used broadly and encompass direct and indirect connections, couplings, and mountings. Similarly, the terms "facing," "faces" and variations thereof herein are used broadly and encompass direct and indirect facing, and "adjacent to" and variations thereof herein are used broadly and encompass directly and indirectly "adjacent to". Therefore, the description of "A" component facing "B" component herein may contain the situations that "A" component directly faces "B" component or one or more additional components are between "A" component and "B" component. Also, the description of "A" component "adjacent to" "B" component herein may contain the situations that "A" component is directly "adjacent to" "B" component or one or more additional components are between "A" component and "B" component. Accordingly, the drawings and descriptions will be regarded as illustrative in nature and not as restrictive.

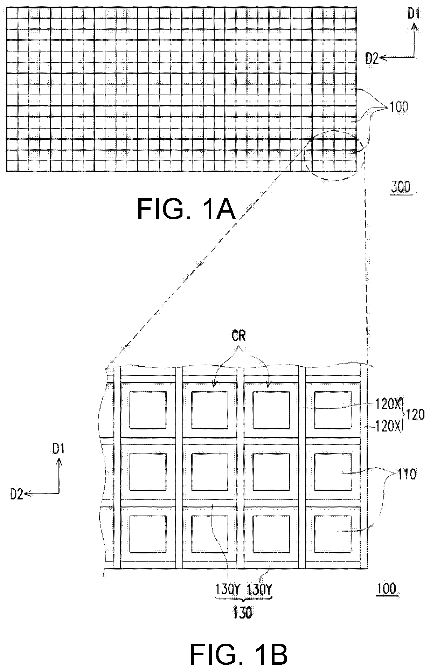

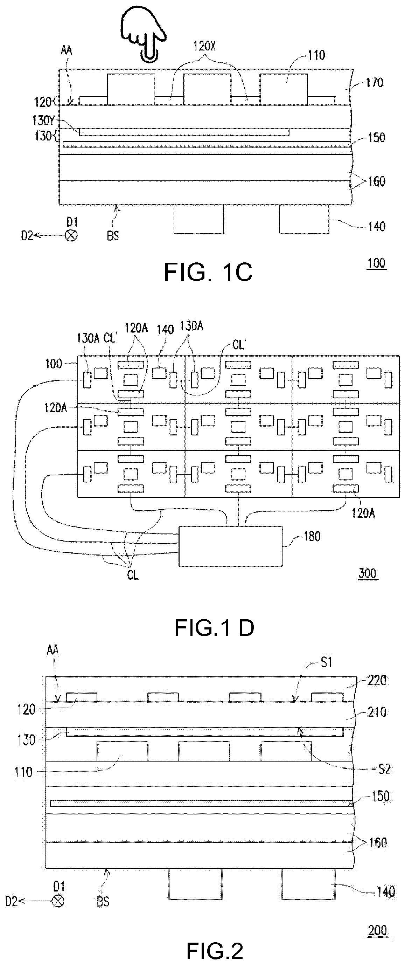

FIG. 1A is a top view of a touch display apparatus according to an embodiment of the invention. FIG. 1B is an enlarged view of a touch display unit of FIG. 1A. FIG. 1C is a cross-sectional view of the touch display unit of FIG. 1B. FIG. 1D is a schematic diagram of a bottom view of the touch display apparatus of FIG. 1A. Referring to FIG. 1A to FIG. 1C, the touch display apparatus of the embodiment has a first surface. To be specific, as shown in FIG. 1A to FIG. 1C, in the embodiment, the touch display apparatus 300 includes at least one touch display unit 100, and each of the touch display units 100 has the first surface. Each of the touch display units 100 includes a plurality of light-emitting elements 110, a first touch electrode layer 120 and a second touch electrode layer 130. For example, in the embodiment, the light-emitting element 110 is a light-emitting diode (LED), and the touch display apparatus 300 is a LED display apparatus having a touch function.

To be specific, as shown in FIG. 1B and FIG. 1C, in the embodiment, the plurality of light-emitting elements 110 are located on a first surface AA of a substrate. The substrate is, for example, made of a polyester material (PET), though the invention is not limited thereto. The substrate is disposed between the first touch electrode layer 120 and the second touch electrode layer 130. The first touch electrode layer 120 is also located on the first surface AA. Moreover, as shown in FIG. 1C, the light emitting element 110 and the first touch electrode layer 120 are located on a same plane. Moreover, as shown in FIG. 1B, in the embodiment, the first touch electrode layer 120 of the touch display unit 100 has a plurality of first axial electrodes 120X extending along a first direction D1. The second touch electrode layer 130 has a plurality of second axial electrodes 130Y extending along a second direction D2. For example, in the embodiment, the first direction D1 is substantially perpendicular to the second direction D2, though the invention is not limited thereto.

To be specific, as shown in FIG. 1C, in the embodiment, the second axial electrodes 130Y and the first axial electrodes 120X are disposed on two opposite surfaces of the substrate. The first touch electrode layer 120 is located between a touch object (for example, a hand) and the second touch electrode layer 130. Viewing toward a direction from the touch object to the touch display apparatus 300, orthographic projections of the first axial electrodes 120X on the first surface AA and orthographic projections of the second axial electrodes 130Y on the first surface AA commonly surround a plurality of closed regions CR, and the plurality of light-emitting elements 110 are respectively located in the corresponding closed region CR. In the embodiment, one closed region CR is configured with one light-emitting element 110, though the invention is not limited thereto, and in other embodiments, as the size of the light-emitting element 110 becomes smaller, the number of the light-emitting elements 110 configured in the single closed region CR may be plural.

Therefore, when the touch object touches the first surface AA of the touch display apparatus 300, capacitance between the touch object and the first axial electrodes 120X of the first touch electrode layer 120 and the second axial electrodes 130Y of the second touch electrode layer 130 may be varied, and the touch display apparatus 300 may sense and calculate a touch position of the touch object according to the capacitance variations, so as to achieve good reliability. Moreover, since the touch display apparatus 300 adopts the first touch electrode layer 120 and the second touch electrode layer 130 to achieve the touch function, it is unnecessary to set high-cost sensors, and the touch display apparatus 300 may achieve a multi-touch function.

On the other hand, as shown in FIG. 1C, in the embodiment, the touch display unit 100 has a bottom surface BS, and the first surface AA is opposite to the bottom surface BS, and each of the touch display units 100 further includes a plurality of driving units 140. The driving units 140 are, for example, LED driving circuits. In other embodiments, each of the touch display units 100 may include a single driving unit 140. The driving units 140 are located on the bottom surface BS, where the light-emitting elements 110 are electrically connected to the driving units 140. In this way, the light-emitting elements 110 may be respectively controlled by the driving units 140 disposed on the bottom surface BS to light up, so that the touch display apparatus 300 achieves a function of display images.

Moreover, as shown in FIG. 1C, in the embodiment, the touch display apparatus 300 further includes a grounding layer 150 and a Printed Circuit Board (PCB) 160 located between the driving units 140 and the second touch electrode layer 130. For example, in the embodiment, the PCB 160 may be configured with a plurality of traces (electrical connection lines) (not shown) used for electrically connecting the driving units 140, the light-emitting elements 110 or other components required to be electrically connected. Moreover, in the embodiment, the PCB 160, for example, presents a black color, e.g. has a black color or a covering in black on the surface facing the light-emitting elements 110, so as to improve contrast of a display image viewed by the user. Moreover, as shown in FIG. 1C, in the embodiment, the grounding layer 150 is located between the PCB 160 and the second touch electrode layer 130. In this way, the touch display apparatus 300 may isolate interference on the second touch electrode layer 130 or the first touch electrode layer 120 caused by noises generated from the traces on the PCB 160 through configuration of the grounding layer 150, so as to achieve a good touch function.

As shown in FIG. 1C, in the embodiment, the touch display apparatus 300 further includes a hardened layer 170 covering the light-emitting elements 110. For example, in the embodiment, the hardened layer 170 may be a hardened Optically Clear Adhesives (OCA) layer, which is adapted to light penetration. In this way, by configuring the hardened layer 170, the hardened layer 170 reduces a risk of damage of the light-emitting elements 110 caused by frequent touch by the touch object or collision with other foreign matters. Moreover, in the embodiment, a surface of the hardened layer 170 away from the first surface AA is, for example, a polished surface, which improves comfort of the touch. In other embodiments, the surface of the hardened layer 170 away from the first surface AA is, for example, a rough surface, which improves a user experience of the touch.

On the other hand, as shown in FIG. 1A and FIG. ID, in the embodiment, the number of the at least one touch display unit 100 is plural, and the touch display units 100 are arranged in an array. The touch display apparatus 300 further includes a plurality of first leads CL and a control unit 180, which are all located on the bottom surface BS. The control unit 180 is, for example, a touch signal processor, which is used for determining a coordinate position of the touch point, or other programmable general purpose or special purpose microprocessor, a Digital Signal Processor (DSP), a programmable controller, an Application Specific Integrated Circuits (ASIC), a Programmable Logic Device (PLD), or other similar device or a combination of the above devices.

FIG. ID is a schematic diagram of a bottom view of the touch display unit of FIG. 1A. For example, in the embodiment, each of the touch display units 100 further includes a first touch electrode layer connection terminal 120A and a second touch electrode layer connection terminal 130A. The first touch electrode layer connection terminal 120A is electrically connected to the first touch electrode layer 120 through internal leads (not shown) penetrating through the PCB 160. The second touch electrode layer connection terminal 130A is electrically connected to the second touch electrode layer 130 through the internal leads (not shown) penetrating through the PCB 160.

The first leads CL respectively have first ends and second ends. The first ends of the first leads CL are respectively electrically connected to the first touch electrode layer connection terminal 120A and the second touch electrode layer 130 of each of the touch display units 100. It should be noted that the first ends of the first leads CL connect a plurality of touch display units 100 at the outermost periphery of the touch display apparatus 300, where at least one side of each of the touch display units 100 at the outermost periphery does not contact another touch display unit 100. The second ends of the first leads CL are electrically connected to the control unit 180.

In the embodiment, the second leads CL' are used for electrically connecting a plurality of first touch electrode layer connection terminals 120A of a plurality of adjacent touch display units 100, and the second leads CL' are used for electrically connecting a plurality of second touch electrode layer connection terminals 130A of a plurality of adjacent touch display units 100. As shown in FIG. ID, in the embodiment, the control unit 180 is also electrically connected to the first touch electrode layer connection terminals 120A and the second touch electrode layer connection terminals 130A of the touch display units 100 through the first leads CL.

In this way, in the touch display apparatus 300, the touch display units 100 may be electrically connected through the second leads CL'. Moreover, through the electrical connection of the first touch electrode layer connection terminals 120A and the second touch electrode layer connection terminals 130A, the first touch electrode layer 120 and the second touch electrode layer 130 may be respectively electrically connected to the first touch electrode layer 120 and the second touch electrode layer 130 of the other touch display unit 100, so as to expand a touch range, and implement the touch detection function of each of the touch display units 100. Moreover, since the first leads CL and the second leads CL' are disposed on the bottom surface BS without passing through the first surface AA, it is unnecessary to additionally set a border to shield the first leads CL, so as to achieve a borderless design, and the touch display units 100 may be designed and arranged according to an actual requirement, and may be arbitrarily expanded to form different contours of the touch display apparatus 300.

In this way, based on the configuration of the first touch electrode layer 120 and the second touch electrode layer 130 in the touch display units 100, the touch display apparatus 300 may sense and calculate a touch position according to the capacitance variations of the axial electrodes therein, so as to implement the touch function. Moreover, since the touch display apparatus 300 implements the display and touch functions simultaneously by integrates the LED display apparatus and the capacitive touch technique based on the configuration that the light emitting elements 110 and the first touch electrode layer 120 are all located on the first surface AA, the touch display apparatus 300 is not affected by environmental light and dust, and is not easy to cause misjudgement, so as to achieve good reliability. The touch display apparatus 300 may also achieve the borderless design through the configuration of the first leads CL on the bottom surface BS, and the touch display units 100 may be designed and arranged according to an actual requirement, and may be arbitrarily expanded to form different contours of the touch display apparatus 300.

FIG. 2 is a cross-sectional view of another touch display unit according to an embodiment of the invention. The touch display unit 200 of FIG. 2 is similar to the touch display unit 100 of FIG. 1C, and differences there between are as follows. As shown in FIG. 2, in the embodiment, the first touch electrode layer 120 and the light emitting elements 110 are not located on a same plane. To be specific, as shown in FIG. 2, in the embodiment, the touch display unit 200 further includes an optical film 210 and a cover 220, where the cover 220 is located on the optical film 210. The optical film 210 and the cover 220 are, for example, made of a transparent material. The optical film 210 has a first side S1 and a second side S2 opposite to each other, and the first touch electrode layer 120 and the second touch electrode layer 130 of each touch display unit 200 are respectively located on the first side S1 and the second side S2 of the optical film 210. For example, in the embodiment, the material of the optical film 210 may be a polyester film (PET film), though the invention is not limited thereto. In another embodiment, the optical film 210 may also be replaced by glass.

Moreover, as shown in FIG. 2, in the embodiment, the optical film 210 covers the light-emitting elements 110. For example, in the embodiment, the method of covering the light-emitting elements 110 by the optical film 210 in the touch display unit 200 is implemented by respectively forming the first touch electrode layer 120 and the second touch electrode layer 130 on the first side S1 and the second side S2 of the optical film 210, and then adhering the optical film 210 on the light-emitting elements 110. In this way, as shown in FIG. 2, in the embodiment, the second touch electrode layer 130 is located between the light-emitting elements 110 and the first touch electrode layer 120.

In this way, the touch display unit 200 may also sense and calculate a touch position according to the capacitance variations of the axial electrodes therein based on the configuration of the first touch electrode layer 120 and the second touch electrode layer 130, so as to implement the touch function, and the touch display unit 200 is adapted to be applied to the aforementioned touch display apparatus 300. Moreover, when the touch display unit 200 is applied to the aforementioned touch display apparatus 300, the touch display apparatus 300 may also achieve the aforementioned effects and advantages, and details thereof are not repeated.

Moreover, when the touch display unit 200 is applied to the aforementioned touch display apparatus 300, a plurality of PCBs 160 and the light-emitting elements 110 thereon are arranged into a required size and contour in an array, and then the optical film 210 and the first touch electrode layer 120 and the second touch electrode layer 130 thereon are adhered on the light-emitting elements 110.

In summary, the embodiment of the invention has at least one of following advantages or effects. In the embodiment of the invention, based on configuration of the first touch electrode layer and the second touch electrode layer in the touch display unit, the touch display apparatus sense and calculate a touch position according to a capacitance variation of the axial electrodes therein, so as to implement the touch function. Moreover, since the touch display apparatus implements the display function and the touch function simultaneously by integrates a display device and a capacitive touch technique based on the configuration that the light-emitting elements and the first touch electrode layer are all located on the first surface, it is not affected by environmental light and dust, and is not easy to cause misjudgement, and has good reliability. The touch display apparatus may also achieve a borderless effect based on the configuration of the leads on the bottom surface, and the touch display units may be designed and arranged according to an actual requirement, and may be arbitrarily expanded to form different contours of the touch display apparatus.

The foregoing description of the preferred embodiments of the invention has been presented for purposes of illustration and description. It is not intended to be exhaustive or to limit the invention to the precise form or to exemplary embodiments disclosed. Accordingly, the foregoing description should be regarded as illustrative rather than restrictive. Obviously, many modifications and variations will be apparent to practitioners skilled in this art. The embodiments are chosen and described in order to best explain the principles of the invention and its best mode practical application, thereby to enable persons skilled in the art to understand the invention for various embodiments and with various modifications as are suited to the particular use or implementation contemplated. It is intended that the scope of the invention be defined by the claims appended hereto and their equivalents in which all terms are meant in their broadest reasonable sense unless otherwise indicated. Therefore, the term "the invention", "the present invention" or the like does not necessarily limit the claim scope to a specific embodiment, and the reference to particularly preferred exemplary embodiments of the invention does not imply a limitation on the invention, and no such limitation is to be inferred. The invention is limited only by the scope of the appended claims. The abstract of the disclosure is provided to comply with the rules requiring an abstract, which will allow a searcher to quickly ascertain the subject matter of the technical disclosure of any patent issued from this disclosure. It is submitted with the understanding that it will not be used to interpret or limit the scope or meaning of the claims. Any advantages and benefits described may not apply to all embodiments of the invention. It should be appreciated that variations may be made in the embodiments described by persons skilled in the art without departing from the scope of the present invention as defined by the following claims. Moreover, no element and component in the present disclosure is intended to be dedicated to the public regardless of whether the element or component is explicitly recited in the following claims.

## Claims

1. A touch display apparatus (300), comprising: at least one touch display unit (100, 200), and the at least one touch display unit (100, 200) comprising: a first surface (AA), a plurality of light-emitting elements (110), a first touch electrode layer (120) and a second touch electrode layer (130), wherein
the plurality of light-emitting elements (110) are located on the first surface (AA);
the first touch electrode layer (120) is located on the first surface (AA), and has a plurality of first axial electrodes (120) extending along a first direction (D1); and
the second touch electrode layer (130) has a plurality of second axial electrodes (130Y) extending along a second direction (D2), wherein orthographic projections of the first axial electrodes (120X) on the first surface (AA) and orthographic projections of the second axial electrodes (130Y) on the first surface (AA) commonly surround a plurality of closed regions (CR), and the plurality of light-emitting elements (110) are respectively located in the corresponding closed regions (CR).

2. The touch display apparatus (300) as claimed in claim 1, wherein the at least one touch display unit (100, 200) has a bottom surface (BS), and the first surface (AA) is opposite to the bottom surface (BS).

3. The touch display apparatus (300) as claimed in claim 1 or 2, wherein the at least one touch display unit (100, 200) further comprises a plurality of driving units (140), located on the bottom surface (BS), wherein the plurality of light-emitting elements (110) are electrically connected to the plurality of driving units (140).

4. The touch display apparatus (300) as claimed in claim 3, further comprising a grounding layer (150), located between the plurality of driving units (140) and the second touch electrode layer (130).

5. The touch display apparatus (300) as claimed in claim 3 or 4, wherein the at least one touch display unit (100, 200) further comprises a printed circuit board (160) located between the plurality of driving units (140) and the second touch electrode layer (130).

6. The touch display apparatus (300) as claimed in claim 5, wherein the printed circuit board (160) presents a black color.

7. The touch display apparatus (300) as claimed in any one of the preceding claims, wherein a plurality of the at least one touch display unit (100, 200) is provided.

8. The touch display apparatus (300) as claimed in any one of the preceding claims, wherein the touch display apparatus (100, 200) further comprises a plurality of first leads (CL), a first touch electrode layer connection terminal (120A) and a second touch electrode layer connection terminal (130A).

9. The touch display apparatus (300) as claimed in claim 8, wherein the first leads (CL) respectively have first ends and second ends, and the first ends of the first leads (CL) are respectively electrically connected to the first touch electrode layer connection terminal (120A) and the second touch electrode layer connection terminal (130A).

10. The touch display apparatus as claimed in claim 9, further comprising a control unit (180), connected to the second ends of the plurality of first leads (CL), and electrically connected to the first touch electrode layer connection terminal (120A) and the second touch electrode layer connection terminal (130A) of the plurality of touch display units (100, 200) through the plurality of first leads (CL).

11. The touch display apparatus as claimed in claim 7, wherein the plurality of touch display units (100, 200) are arranged in an array.

12. The touch display apparatus as claimed in any one of the preceding claims, further comprising a hardened layer (170), covering the plurality of light-emitting elements (110).

13. The touch display apparatus as claimed in any one of the preceding claims, wherein the plurality of light-emitting elements (110) and the first touch electrode layer (120) are located on a same plane.

14. The touch display apparatus as claimed in any one of the preceding claims, further comprising:
an optical film (210), covering the plurality of light-emitting elements (110), wherein the optical film (210) has a first side (S1) and a second side (S2) opposite to each other, and the first touch electrode layer (120) and the second touch electrode layer (130) of the at least one touch display unit (100, 200) are respectively located on the first side (S1) and the second side (S2) of the optical film (210); and further preferably includes a cover (220), located on the optical film (210).

15. The touch display apparatus as claimed in claim 14, wherein the second touch electrode layer (130) is located between the plurality of light-emitting elements (110) and the first touch electrode layer (120).
